# EUROPEAN PATENT APPLICATION

(11) **EP 4 303 936 A1**
(43) Date of publication of application: **10.01.2024**
(21) Application number: 21928352.0
(22) Date of filing: 02.07.2021
(51) Int. Cl.: H01L 31/0224

(54) **TRANSPARENT ELECTRODE, METHOD FOR PRODUCING SAME, AND ELECTRONIC DEVICE USING TRANSPARENT ELECTRODE**

(30) Priority: 04.03.2021 WO PCT/JP2021/008485
(71) Applicant: KABUSHIKI KAISHA TOSHIBA, Minato-ku Tokyo 105-0023 (JP); Toshiba Energy Systems & Solutions Corporation, Kawasaki-shi, Kanagawa 212-0013 (JP)
(72) Inventor: SHIDA Naomi, Tokyo 1050023 (JP); NAITO Katsuyuki, Tokyo 1050023 (JP); SAITA Yutaka, Kawasaki-shi Kanagawa 2120013 (JP)
(74) Representative: Hoffmann Eitle
(86) International application number: PCT/JP2021/025097
(87) International publication number: WO 2022/185559

(57) **Abstract**

To provide a transparent electrode that hardly causes migration of silver and has high resistance, a method for producing the same, and an electronic device using the transparent electrode.

A transparent electrode according to the embodiment includes a laminated structure in which a transparent base material, a conductive silver-containing layer, and a conductive oxide layer are laminated in this order,
wherein a ratio T₈₀₀/T₆₀₀ of total transmittances of the transparent electrode is 0.85 or more, where T800 and T₆₀₀ are transmittances at wavelengths of 800 nm and 600 nm, respectively, and
the silver-containing layer is continuous. This electrode can be produced by bringing sulfur or a sulfur compound into contact with a laminated film in which a conductive silver-containing layer and a conductive oxide layer are laminated to form a sulfur-containing silver compound layer.

## Description

### TECHNICAL FIELD

Embodiments of the present invention relate to a transparent electrode, an element using the transparent electrode, and a method for producing the element.

### BACKGROUND ART

In recent years, energy consumption has been increasing, and there is an increasing demand for alternative energy to replace conventional fossil energy as a global warming countermeasure. Attention has been focused on a solar cell as a source of such alternative energy, and development of the solar cell has been in progress. Use of the solar cell for various applications has been investigated; however, flexibility and durability of the solar cell are particularly important in order to cope with various installation places. The most basic monocrystalline silicon-based solar cell is expensive and difficult to be made flexible, and organic solar cells and organic-inorganic hybrid solar cells that have recently attracted attention have room for improvement in terms of durability.

In addition to such a solar cell, photoelectric conversion elements such as an organic EL element and an optical sensor have been investigated for the purpose of flexibility and durability improvement. In such an element, an indium-doped tin oxide film (ITO film) is widely used as a transparent positive electrode. The ITO film is typically formed by sputtering or the like, and in order to achieve high conductivity, sputtering at a high temperature or high-temperature annealing after sputtering is generally required, and the ITO film is often inapplicable to an organic material.

In addition, ITO/Ag alloy/ITO having low resistance and high transparency may be used as a transparent electrode. However, in an electrode including such a silver alloy, silver ions tend to migrate easily. For this reason, in an electronic device including an electrode having a silver alloy, when the migrated silver ions reach the element active portion inside the device, the element activity itself may decrease.

### CITATION LIST

### PATENT LITERATURE

Patent Literature 1: JP 2002-540459 W

### SUMMARY OF THE INVENTION

### OBJECT OF THE INVENTION

In view of the above problem, the present embodiment provides a transparent electrode that hardly causes migration of silver ions and has high durability, a method for producing the transparent electrode, and an electronic device (photoelectric conversion element or the like) using the transparent electrode.

### SOLUTION TO PROBLEM

A transparent electrode according to the embodiment has a laminated structure in which a first conductive silver-containing layer and a conductive oxide layer are laminated in this order,
wherein a ratio T₈₀₀/T₆₀₀ of total transmittances of the transparent electrode is 0.85 or more, where T₈₀₀ and T₆₀₀ are transmittances at wavelengths of 800 nm and 600 nm, respectively, and
the silver-containing layer is continuous when a cross section of the transparent electrode is observed with a scanning electron microscope.

In addition, the transparent electrode according to the other embodiment has a laminated structure in which a conductive silver-containing layer and a first conductive oxide layer are laminated in this order,
wherein the silver-containing layer is continuous when a cross section of the transparent electrode is observed with a scanning electron microscope, and the first conductive oxide layer has a sulfur-containing silver compound.

A method for producing a transparent electrode according to the embodiment is a method for producing a transparent electrode by producing a laminated film in which a conductive silver-containing layer and the first conductive oxide layer are laminated in this order, and includes a step (b) of bringing sulfur or a sulfur compound into contact with the laminated film.

The electronic device according to the embodiment has the transparent electrode, an active layer, and a counter electrode.

### BRIEF DESCRIPTION OF DRAWINGS

FIG. 1 is a conceptual view showing a structure of a transparent electrode according to an embodiment.
FIG. 2 is a conceptual view showing a structure of another transparent electrode according to an embodiment.
FIG. 3 is a conceptual view showing a structure of still another transparent electrode according to the embodiment.
FIG. 4A is a conceptual view showing a method for producing a transparent electrode according to the embodiment.
FIG. 4B is a conceptual view of a transparent electrode producing apparatus capable of performing the method for producing the transparent electrode according to the embodiment.
FIG. 5 is a conceptual view showing a structure of a photoelectric conversion element (solar battery cell) according to an embodiment.
FIG. 6 is a conceptual view showing a structure of a photoelectric conversion element (organic EL element) according to an embodiment.
FIG. 7 shows cross-sectional SEM images of transparent electrodes in Example 1 and Comparative Example 1 (magnification: 80,000).
FIG. 8 is a conceptual view showing a structure of a photoelectric conversion element (solar battery cell) of Example 5.

### BEST MODE FOR CARRYING OUT THE INVENTION

Hereinafter, embodiments will be described in detail with reference to the drawings.

### [Embodiment 1-1]

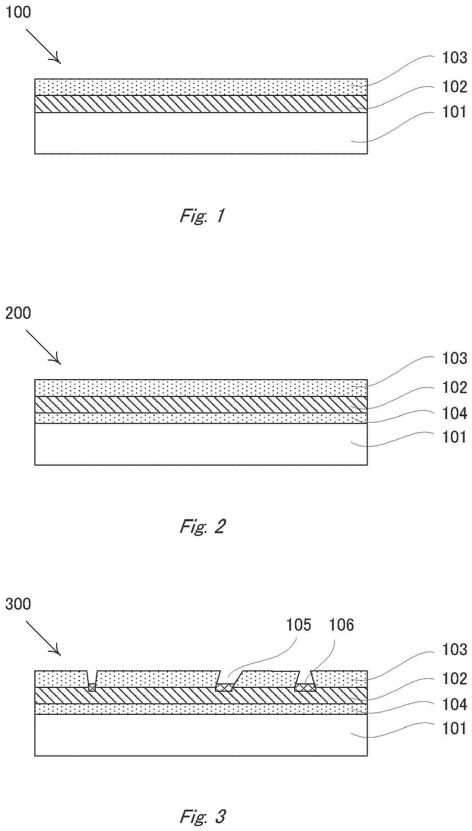

A configuration of the transparent electrode according to the first embodiments will be described with reference to FIG. 1. FIG. 1 is a schematic configuration view of a transparent electrode 100 according to the present embodiment.

This transparent electrode has a laminated structure of a silver-containing layer 102 and a first conductive oxide layer 103 on a transparent base material 101. The transparent base material is not essential, and the silver-containing layer and the first conductive oxide layer may be provided on another base material. All of these layers are conductive and are light transmissive. This transparent electrode is characterized in that a ratio T₈₀₀/T₆₀₀ of transmittances when total transmittances at wavelengths of 800 nm and 600 nm are denoted by T₈₀₀ and T₆₀₀, respectively, is 0.85 or more, and the silver-containing layer is continuous when a cross section of the transparent electrode is observed with a scanning electron microscope, wherein the total transmittance is a transmittance including linearly transmitted light and backscattered light, and is measured using an integrating sphere.

Examples of the material of the base material 101 include resin materials such as polyethylene terephthalate (hereinafter, referred to as PET) and polyethylene naphthalate (hereinafter, referred to as PEN). The base material is preferably flattened. In addition, the total transmittance of the transparent base material singly at 550 nm is preferably 85% or more.

The silver-containing layer needs to contain silver, but may be silver or a silver alloy containing silver. Generally, the content of silver in the silver alloy is low, tending to a lower ratio of T₈₀₀/T₆₀₀, and therefore the content of silver is preferably high, and the silver-containing layer is most preferably composed of silver.

The film thickness of the silver-containing layer 102 is appropriately adjusted according to transparency and conductivity, and the film thickness is preferably 4 to 20 nm. When the thickness is smaller than 4 nm, the resistance tends to increase, and when the thickness is larger than 20 nm, the transparency tends to decrease. The film thickness of the silver-containing layer is more preferably 5 to 15 nm, and still more preferably 6 to 10 nm. The silver-containing layer 101 can be produced by, for example, sputtering or vapor deposition, and is preferably produced by sputtering.

As the oxide constituting the first conductive oxide layer (hereinafter, the oxide layer may be referred to as a first oxide layer or an oxide layer) 103, an oxide having appropriate transparency and conductivity can be selected from generally known optionally oxides. Specific examples thereof include indium-doped tin oxide (indium doped tin oxide, hereinafter referred to as ITO), fluorine-doped tin oxide (fluorine doped tin oxide, hereinafter referred to as FTO), and aluminum-doped zinc oxide (aluminum doped zinc oxide, hereinafter referred to as AZO). Among these, ITO is preferable because ITO easily forms a layer having high flatness, and the zeta potential is close to 0 at neutral pH, and the interaction with cations and anions is small.

These oxides generally often contain an amorphous structure. The amorphous structure is preferable because of easily forming a continuous, uniform, and flat film. In addition, the thickness of the oxide layer is preferably 30 to 200 nm. When the thickness of the oxide layer is less than 30 nm, the resistance tends to increase, and when the thickness is more than 200 nm, the transparency decreases, and it takes time to produce the oxide layer. The film thickness of the oxide layer is more preferably 35 to 100 nm, and still more preferably 40 to 70 nm.

The oxide layer 103 can be produced, for example, by sputtering at a low temperature. The amorphous oxide film can be annealed to partially crystallize the amorphous oxide to form a mixture (amorphous-containing oxide layer).

FIG. 2 is a conceptual view of another transparent electrode according to the embodiment. In this transparent electrode, a second conductive oxide layer (hereinafter, may be referred to as a second oxide layer) 104 is further provided between the base material 101 and the silver-containing layer 102. The oxide constituting the second oxide layer 104 can be selected from the oxides described in the first oxide layer 103. The first oxide layer 103 and the second oxide layer 104 may have the same composition or different compositions.

From the viewpoint of transparency and conductivity, the first oxide layer 103 and the second oxide layer 104 are preferably made of ITO. That is, the transparent electrode according to the embodiment preferably has a laminated structure of ITO/silver-containing layer/ITO.

FIG. 3 is a conceptual view of still another transparent electrode according to the embodiment. The oxide layer 103 may have fine ununiform portions 105. Such an ununiform portion easily causes migration of silver, and thus is preferably blocked by the sulfur-containing silver compound 106 or the like. The ununiform portion corresponds not only to a void or an opening as illustrated in FIG. 3 but also to a region having a density lower than that of the periphery. The ununiform portion can also be observed using, for example, a scanning electron microscope or a transmission electron microscope. According to these electron microscopes, in addition to voids and openings, a region having a low oxide density is observed to be darker than its surroundings due to less electron scattering. Specifically, an ULTRA55 type microscope (observation voltage: 2.0 kV, magnification: 80,000 times) manufactured by Carl Zeiss Co., Ltd. as a field emission type scanning electron microscope and an H-9500 type microscope (magnification: 2 million times) manufactured by Hitachi High-Technologies Corporation as a transmission electron microscope can be used.

The combination of the silver-containing layer and the first oxide layer, and the second oxide layer and the sulfur-containing silver compound 106 provided as necessary may be referred to as a conductive layer for convenience.

In the transparent electrode according to the embodiment, when the total transmittance at a wavelength of 800 nm is denoted by T₈₀₀ and the total transmittance at a wavelength of 600 nm is denoted by T₆₀₀, the ratio T₈₀₀/T₆₀₀ (hereinafter, may be referred to as Rₜ) is 0.85 or more. When silver in the silver-containing transparent electrode is close to pure silver, a decrease in light transmittance at a long wavelength can be reduced. When Rₜ is 0.85 or more, light on the long wavelength side can be passed, and the energy conversion efficiency of the solar cell can be increased. Rₜ is more preferably 0.88 or more, still more preferably 0.9 or more. The ratio Rₜ of less than 0.85 is not preferable regardless of migration resistance tends to increase, because the light transmittance of the entire transparent electrode tends to decrease. In addition, small Rₜ tends to increase electric resistance.

In order to increase Rₜ, it is effective to increase the silver content of the silver-containing layer. Therefore, the silver-containing layer is preferably composed of pure silver. Whereas, when the silver content of the silver-containing layer is high, migration easily occurs and deterioration easily occurs. From such a viewpoint, the content of silver in the silver-containing layer is preferably 90 to 100 atom%, and more preferably 96 to 99 atom%, based on the number of atoms of the silver-containing layer.

Conventionally, a transparent electrode having a laminated structure of a silver-containing layer and an oxide layer has been known. Thus, there may be a silver-containing layer having a high silver content. However, in such a transparent electrode, migration of silver ions cannot be controlled, and as a result, durability of the transparent electrode and an electronic device including the transparent electrode is often insufficient.

In the transparent electrode according to the embodiment, migration of silver ions is suppressed by adopting a continuous silver-containing layer as the silver-containing layer. The continuous silver-containing layer hardly causes migration of silver although an electronic device such as a solar cell is driven for a long period of time, and the lifetime tends to be long.

The continuity of such a silver-containing layer can be evaluated by observing a cross section of the transparent electrode using a scanning electron microscope (hereinafter, may be referred to as SEM). When the sample is observed by SEM, the sample is irradiated with an electron beam. When the silver-containing layer is irradiated with an electron beam, electrons are easily retained on the surface of the sample, so that an electric field is generated. This electric field tends to cause migration of silver. When migration of silver occurs, a discontinuous region is formed in the silver-containing layer. In the embodiment, a silver-containing layer in which a discontinuous region is not confirmed by SEM as described above is referred to as being continuous. Such SEM observation can also be considered to accelerate migration of silver in the transparent electrode or the electronic device, and thus can also be applied to prediction of the life of the transparent electrode or the electronic device.

In the embodiment, "the silver-containing layer is continuous" means that there are 2 or less of discontinuous regions in the silver-containing layer having a length of 1.4 µm when 5 randomly selected cross sections of the transparent electrode are observed with a SEM at a magnification of 80,000 times. In the embodiment, it is preferable that no discontinuous region is observed. The discontinuous region is observed as a black shadow having a major axis of 15 nm or more in the SEM image.

According to the study of the present inventors, such a discontinuous region is easily formed when there is an ununiform portion in the oxide layer formed on the silver-containing layer. Generally, the oxide layer is formed by sputtering or the like, and it is difficult to form a dense oxide layer without an ununiform portion. Thus, in a general transparent electrode, the oxide layer often includes minute ununiform portions. In this case, it is considered that migration of silver is facilitated in an ununiform portion in which a part of the silver-containing layer is not sufficiently covered with a uniform and dense oxide layer, and a discontinuous region is formed in the silver-containing layer.

In the transparent electrode including the oxide layer having the ununiform portion as described above, it is preferable to close the ununiform portion in order to maintain the continuity of the silver-containing layer. Specifically, the oxide layer, particularly the silver-containing layer under the ununiform portion of the oxide layer can be modified to a highly stable compound, or a highly stable compound layer can be provided. Examples of such a highly stable compound include sulfur-containing silver compounds. A typical example of such a sulfur-containing silver compound is silver sulfide, and a compound including a metal other than silver or a chalcogen other than sulfur may be used. In addition, the compound may be a compound obtained by reacting an alkyl thiol or the like with a metal such as silver. As described above, in the transparent electrode according to the embodiment, the oxide layer includes the sulfur-containing silver compound.

In order to close the ununiform portion of the oxide layer, it is convenient to bring sulfur or a sulfur compound into contact with silver or a silver alloy under the ununiform portion to form a sulfur-containing silver compound (details will be described later). Such a method can cause the oxide layer to include the sulfur-containing silver compound. Typically, sulfur or a sulfur compound easily comes into contact with the entire lower part of the ununiform portion, whereby the entire lower part is easily covered with the sulfur-containing silver compound. According to such a method, the entire surface of the silver-containing layer is coated with either a uniform and dense oxide layer or a stable sulfur-containing silver compound layer, thereby suppressing migration of silver ions from the silver or silver alloy layer.

In an embodiment, it is preferable to have a graphene layer or a polystyrene layer on the oxide layer.

In an embodiment, the graphene layer has a structure in which one to several layers of graphene having a sheet shape are laminated. The number of laminated graphene layers is not particularly limited, and is preferably 1 to 6, and more preferably 2 to 4, in order to allow obtaining sufficient transparency, conductivity, or ion shielding effect.

The graphene preferably has a structure in which, for example, a polyalkyleneimine, particularly a polyethyleneimine chain is bonded to a graphene skeleton as shown in the following formula, for example. In addition, the carbon of the graphene skeleton is preferably partially substituted with nitrogen.

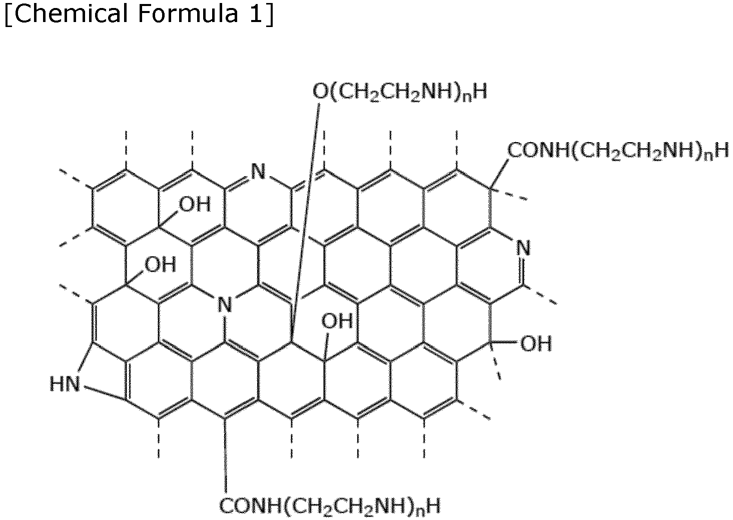

In the above formula, a polyethyleneimine chain is exemplified as a polyalkyleneimine chain. The number of carbon atoms included in the alkyleneimine unit is preferably 2 to 8, and polyethyleneimine including a unit having two carbon atoms is particularly preferable. In addition, there can be used not only the linear polyalkyleneimine but also a polyalkyleneimine having a branched chain or a cyclic structure. Herein, n (the number of repeating units) is preferably 10 to 1000, and more preferably 100 to 300.

The graphene is preferably unsubstituted or nitrogen-doped. Nitrogen-doped graphene is preferable when a transparent electrode is used as a cathode. The doping amount (N/C atomic ratio) can be measured by an X-ray photoelectron spectrum (XPS), and is preferably 0.1 to 30 atom%, and more preferably 1 to 10 atom%. The graphene layer has a high shielding effect, and thus can prevent diffusion of acid and halogen ions to prevent deterioration of metal oxides and metals, and prevent intrusion of impurities from the outside into the photoelectric conversion layer. Furthermore, the nitrogen-substituted graphene layer (N-graphene layer) includes a nitrogen atom, and therefore the trapping ability against an acid is also high and the shielding effect is higher.

In addition, in an embodiment, the polystyrene layer is composed of a homopolymer or copolymer including a styrene polymerization unit as a monomer. When the copolymer is used, other monomers such as acrylic acid and methacrylic acid may be included as long as the effect of the present invention is not impaired, and the content of styrene is preferably high. Specifically, the blending ratio of styrene is preferably 90 mol% or more of the polymerization units included in the copolymer. Typically, a styrene homopolymer is used as polystyrene. The thickness of the polystyrene layer is preferably 0.5 to 2 nm, and more preferably 0.7 to 1.5 nm. When the thickness of the polystyrene layer is excessively thin, it is difficult to obtain a uniform film, and when the thickness is excessively thick, electric resistance tends to increase.

In the embodiment, it is preferable to further include a third inorganic oxide layer on the first oxide layer, the graphene layer, or the polystyrene layer. Examples of the third inorganic oxide include TiO₂, SnO₂, WO₃, NiO, MoO₃, ZnO, and V₂O₅. A conductive oxide may be further laminated. These third inorganic oxide films function as a barrier layer, an insulating layer, a buffer layer, and the like in a transparent substrate or an electronic device. The ratio of metal to oxygen in the third inorganic oxide is not necessarily a stoichiometric ratio.

### [Embodiment 1-2]

Another embodiment 1-2 of the transparent electrode according to the first embodiment will be described. Such a transparent electrode also has a structure as shown in FIG. 1.

This transparent electrode includes a laminated structure in which a conductive silver-containing layer and a first conductive oxide layer are laminated in this order. In addition, when the cross section of the transparent electrode is observed with a scanning electron microscope, the silver-containing layer is continuous. From these viewpoints, the transparent electrode is the same as the transparent electrode of Embodiment 1-1.

In this transparent electrode, the first conductive oxide layer has an ununiform portion, and the ununiform portion includes a sulfur-containing silver compound layer. With such a configuration, high durability can be realized. Here, the transparent electrode according to Embodiment 1-2 is not limited by light transmittance. Therefore, the transmittance ratio T₈₀₀/T₆₀₀ may be less than 0.85, and when the ratio is 0.85 or more, excellent characteristics can be achieved.

### [Embodiment 2]

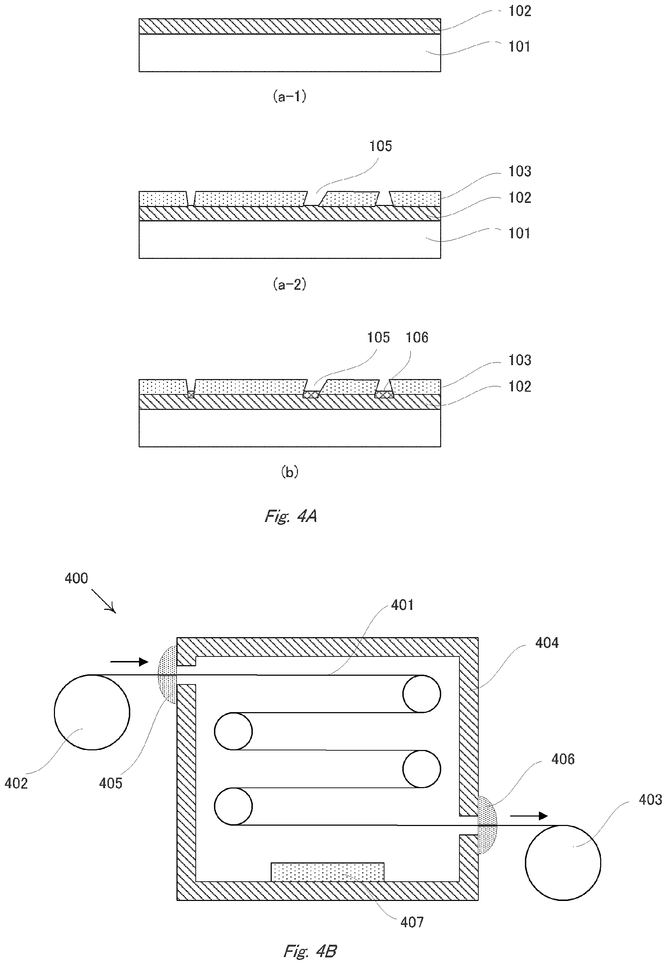

FIG. 4A is a conceptual view showing a method for producing a transparent electrode according to an embodiment. This production method includes a step (b) of bringing sulfur or a sulfur compound into contact with a laminated film in which a conductive silver-containing layer and a first conductive oxide layer are laminated.

First, a laminated film is prepared prior to the step (b). This laminated film is obtained by laminating the conductive silver-containing layer 102 and the first conductive oxide layer 103, and the handling becomes easy by forming the laminated film on the base material. Therefore, it is preferable to prepare a laminate film formed on the transparent base material 101. In order to produce such a laminated film, first, the transparent base material 101 is prepared. The transparent base material 101 is preferably smooth, and can be subjected to a smoothness treatment such as polishing or a corona treatment prior to formation of the silver-containing layer. Then, a conductive silver-containing layer 102 is formed on the transparent base material (FIG. 4A (a-1)). The silver-containing layer can be formed by any conventionally known method, and for example, silver or a silver alloy can be formed by a sputtering method or a vapor deposition method. Particularly, the sputtering method is preferable because of easily forming the uniform silver-containing layer. Alternatively, it can also be produced by applying and heating a dispersion of silver nanoparticles or silver nanowires.

Then, a conductive oxide layer 103 is formed on the silver-containing layer 102 to form a laminated film (FIG. 4A (a)-2). The oxide layer 103 can be formed, for example, by sputtering at a low temperature. An amorphous oxide layer can be formed by low-temperature sputtering, and the amorphous oxide can be partially crystallized by annealing to form a mixture (amorphous oxide layer). Annealing is preferably performed in a high-temperature atmosphere or by laser annealing. Alternatively, the oxide layer can be produced by coating and heating a dispersion of oxide nanoparticles. The oxide layer 103 is formed uniformly, that is, as an unpatterned uniform film on the silver-containing layer 102. However, when the oxide layer is formed by a common method, the ununiform portion 105 is usually inevitably formed on the surface. A laminated film can be produced by such a step (a); however, in an embodiment, such a laminated film may be continuously subjected to the next step (b) after being produced, or a laminated film may be separately produced and then subjected to the step (b).

Thus, sulfur or a sulfur compound is brought into contact with the prepared laminated film in step (b). As a result, the oxide layer contains the sulfur-containing silver compound. Specifically, silver or a silver alloy under the ununiform portion 105 reacts with sulfur or a sulfur compound to form the sulfur-containing silver compound 106, thereby forming the sulfur-containing silver compound layer (FIG. 4A(b)). Incidentally, there may be a case where the silver-containing layer is covered with the sulfur-containing silver compound layer; however, in practice, a part of silver in the silver-containing layer reacts with the sulfur compound to form the sulfur-containing silver compound, and as shown in FIG. 3, a part of the silver-containing layer becomes the sulfur-containing silver compound layer, and the volume of the sulfur-containing silver compound layer increases more than a part of the silver-containing layer before the reaction as the reaction proceeds.

A method for bringing sulfur or a sulfur compound into contact with the laminated film is not particularly limited, and a method for bringing a gas or a liquid including sulfur or a sulfur compound into contact with the laminated film is used. More specifically, methods of
(b1) bringing the laminated film into contact with a sulfur vapor gas;
(b2) bringing the laminated film into contact with hydrogen sulfide gas;
(b3) bringing the laminated film into contact with an aqueous solution of hydrogen sulfide, sodium sulfide, or ammonium sulfide; or
(b4) contacting the laminated membrane with a solution of thioamide or thiourea, or the like, are adopted.

The method of (b1) is a method of heating sulfur powder to generate sulfur vapor gas including clusters of sulfur atoms, and the gas is sprayed onto the laminated film or the laminated film is disposed under the atmosphere of the gas. This gas reacts with silver or a silver alloy exposed at the bottom of the ununiform portion to generate stable silver sulfide. The temperature at which the sulfur powder is heated is preferably 50°C to 300°C. The sulfur vapor gas is preferably generated in dry air or dry nitrogen.

In addition, it is also possible to use a method of dissolving a sulfur powder in toluene, carbon disulfide or the like and spraying or applying the solution to a laminated film, and the resultant is heated and dried. In this method, unreacted sulfur may remain on the laminated film, and therefore post-treatment such as washing may be required.

The method may further include a step of performing nitrogen blowing or solvent washing to remove unreacted sulfur adsorbed on the surface of the transparent electrode.

The method (b2) is a method of spraying hydrogen sulfide gas to the laminated film or arranging the laminated film under the atmosphere of the gas. Hydrogen sulfide can be prepared by any method, and can be utilized by using hydrogen sulfide gas recovered from exhaust gas discharged from a plant or can be produced by reacting methane and sulfur in the presence of a catalyst.

The method (b3) is a method of immersing the laminated film in an aqueous solution of a sulfur compound such as hydrogen sulfide, sodium sulfide, or ammonium sulfide, or spraying or coating the aqueous solution on the laminated film. The silver-containing layer is easily oxidized when an aqueous solution is used, and therefore it is preferable to dry the silver-containing layer in an atmosphere having a low oxygen content after the contact with the aqueous solution. After drying, unreacted sodium sulfide and ammonium sulfide are preferably washed off with water or the like.

The method (b4) is a method of immersing the laminated film in a solution of thioamide or thiourea, or spraying or applying the solution to the laminated film. Thioamide or thiourea is preferably dissolved in water or alcohol. When the solution is applied onto the laminated film, an alcohol solution is preferable from the viewpoint of wettability, and ethanol or methanol is preferable. After the contact, it is preferable to remove the solvent and thioamide or thiourea by heating. It is preferable that the solid residue disappears by evaporation, sublimation, decomposition, or the like in the heating process. From such a viewpoint, the thioamide or thiourea is preferably one having a low boiling point, sublimation point, or decomposition temperature, and specifically, one removed by evaporation or the like at a temperature of 130°C or less is preferable.

The thioamide used in (b4) is represented by the general formula (I): 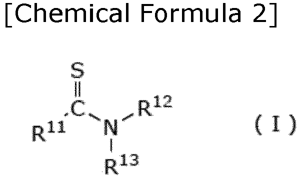 wherein
R¹¹ is hydrogen or a C₁ to C₃ alkyl group,
R¹² and R¹³ are each independently hydrogen or a C₁ to C₃ alkyl group.

Among them,
thioacetamide wherein R¹¹ is a methyl group, and R¹² and R¹³ are hydrogen,
N-methylthioacetamide wherein R¹ is a methyl group, R¹² is a methyl group, and R¹³ is hydrogen,
N,N-dimethylthioacetamide wherein R¹¹ is a methyl group, and R¹² and R¹³ are a methyl group,
thiopropoxyamide in which R¹¹ is an ethyl group and R¹² and R¹³ are hydrogen, or
N,N-dimethylthioformamide wherein R¹¹ is hydrogen, and R¹² and R¹³ are a methyl group, is preferable because solubility and reactivity are excellent, and a solid residue hardly remains. Particularly, thioacetamide is preferable.

The thioamide used in (b4) is represented by the general formula (II): 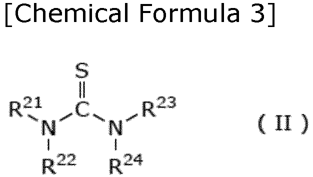 wherein
R²¹ to R²⁴ are each independently hydrogen or a C₁ to C₃ alkyl group.

Among them,
N-methylthiourea wherein R²¹ is a methyl group, and R²², R²³ and R²⁴ are hydrogen,
N,N'-dimethylthiourea wherein R²¹ and R²³ is a methyl group, R²² and R²⁴ are hydrogen or
N, N-dimethylthiourea wherein R²¹ and R²² are a methyl group, and R²² and R²³ are hydrogen,
is preferable from the viewpoint of solubility and reactivity.

Thioamide or thiourea is preferably dissolved in water or alcohol. When the solution is applied onto the laminated film, an alcohol solution is preferable from the viewpoint of wettability, and ethanol or methanol is preferable. After the contact, it is preferable to dry by heating. It is preferable that the solid residue disappears by evaporation, sublimation, decomposition, or the like in the heating process.

In the step (b), an appropriate sulfur-containing silver compound layer can be formed by adjusting the content of the sulfur-containing compound in the gas, the aqueous solution, or the solution. Furthermore, it is preferable to observe the sulfur concentration in the gas or the aqueous solution and adjust the contact conditions according to the observed concentration. The production stability can be enhanced by controlling the reaction time and temperature while observing the sulfur concentration.

The method for producing a transparent electrode according to the embodiment has been described above with reference to FIG. 4A, and FIG. 4B shows a conceptual view of an apparatus (roll-to-roll sulfur vapor treatment apparatus) 400 capable of continuously producing a transparent electrode, which can employ other methods.

In this apparatus, a laminated film 401 (or a transparent base material on which a laminated film is formed) is wound around the feed side roll 402. The laminated film drawn out from the roll passes through the inside of the heating furnace 404 and is then wound around the winding-side roll 403. A sulfur source 407 such as a sulfur powder and a sulfur compound-containing compound solution is disposed in the heating furnace 404, and sulfur vapor or sulfur compound gas such as hydrogen sulfide is brought into contact with the laminated film by heating. According to such an apparatus, a transparent electrode can be continuously produced. The feed side roll or the winding-side roll can be accommodated in the heating furnace (or a space continuous thereto) to seal the whole. However, in this case, the apparatus becomes huge, and therefore it is preferable to limit a space to be treated with sulfur vapor or the like as illustrated in FIG. 4B.

In FIG. 4B, the laminated film or the transparent base material having the laminated film formed thereon is wound around the feed side roll; however, the transparent electrode can also be produced by winding the transparent base material around the feed side roll, arranging a silver-containing layer forming apparatus and a first oxide layer forming apparatus between the feed side roll and the heating furnace to form a laminated film, and subsequently bringing the laminated film into contact with sulfur vapor or the like.

When the laminated film is continuously passed through the atmosphere of either sulfur vapor gas or the hydrogen sulfide gas as described above, it is preferable to control so as not to increase the moisture content or the oxygen content in the atmosphere. For example, if the atmosphere flowing into the heating furnace is not controlled at all, the treatment with sulfur vapor or the like becomes ununiform, and the resistance value or the like of the surface of the laminated film may vary. It is presumed that oxygen and water vapor in the atmosphere, or water vapor brought into the heating furnace by the transparent base material or the like reacts with sulfur vapor or the like to generate sulfurous acid or the like, thereby adversely affecting the laminated film.

Therefore, it is preferable to introduce an inert gas, for example, nitrogen into the heating furnace or to decompress the inside of the heating furnace. Furthermore, more conveniently, the external air inflow prevention units 405 and 406 as shown in FIG. 4B can be provided. These external atmosphere inflow prevention units can provide an effect if only restricting the opening of the introduction port or the discharge port of the laminated film (or the transparent base material having the laminated film formed thereon) to be narrow. In addition, an air curtain, a squeezer, or the like may be used.

In addition, it is preferable to perform control so that the moisture content or the oxygen content in the heating furnace does not increase, and specifically, the oxygen content in the heating furnace is preferably 21% by volume or less, the water vapor content is preferably 0.3% by volume or less, and more preferably 0.1% by volume or less.

The preparation method according to the embodiment may further include a step of forming another layer. An example of such another layer is the second oxide layer described above. That is, the second conductive oxide layer can be formed prior to the formation of the laminated film on the transparent base material.

In addition, the production method according to the embodiment may further include a step (c) of laminating the graphene layer or the polystyrene layer before or after the step (b).

The step of laminating the graphene layers can be performed by any method. For example, a method of forming a graphene film on another support and transferring the graphene film onto an oxide film can be adopted. Specifically, an unsubstituted single-layer graphene film is formed by a CVD method using a copper foil as a base catalyst layer using methane, hydrogen, or argon as a reaction gas, the film is pressure-bonded to an oxide film, and then copper is dissolved to allow transferring the single-layer graphene onto the laminated film. By repeating the same operation, a plurality of single-layer graphene can be laminated on the laminated film. In this case, it is preferable to produce 2 to 4 graphene layers. Instead of unsubstituted graphene, graphene in which a part of carbon is substituted with boron may be used. Boron-substituted graphene can be produced in the same manner by using BH₃, methane, hydrogen, or argon as a reaction gas.

In addition, the step of laminating the polystyrene layer can be performed by any method. For example, there can be adopted a method of dissolving polystyrene in an organic solvent, for example, toluene, and applying or spraying onto the laminated film, and then evaporating and removing the organic solvent.

In addition, the production method according to the embodiment may further include a step (d) of laminating a third inorganic oxide layer before or after the step (b). The step (d) may be performed before or after the step (c). Examples of the inorganic oxide include TiO₂, SnO₂, WO₃, NiO, MoOs, ZnO, and V₂O₅. These inorganic oxide films are generally formed by a sputtering method, a vapor deposition method, a sol-gel method, or the like. The ratios of metal to oxygen in these inorganic oxides are not necessarily stoichiometric ratios.

### [Embodiment 3-1]

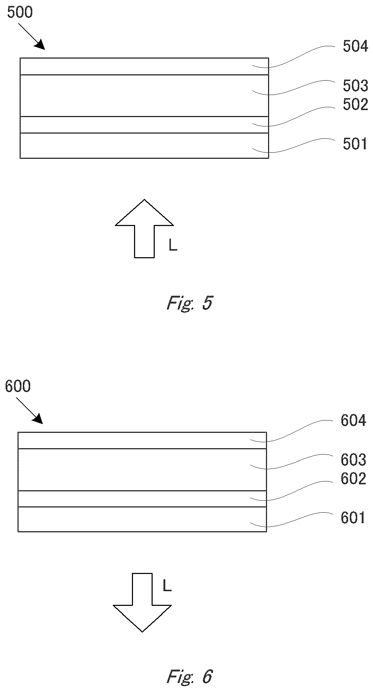

A configuration of a photoelectric conversion element according to one embodiment of a third electronic device will be described with reference to FIG. 5. FIG. 3 is a schematic configuration view of a solar battery cell 500 (photoelectric conversion element) according to the present embodiment. The solar battery cell 500 is an element having a function as a solar battery that converts light energy such as the sunlight L incident on the cell into electric power. The solar battery cell 500 includes a photoelectric conversion layer 503 provided on the surface of a conductive layer 502 on a base material 501, and a counter electrode 504 provided on a side surface of the photoelectric conversion layer 503 opposite to the conductive layer 502. Herein, the conductive layer 502 is similar to that shown in Embodiment 1.

The photoelectric conversion layer 503 is a semiconductor layer that converts light energy of incident light into electric power to generate a current. The photoelectric conversion layer 503 generally includes a p-type semiconductor layer and an n-type semiconductor layer. The photoelectric conversion layer may be a laminate of a p-type polymer and an n-type material, perovskite RNH₃PbX₃ (R is an alkyl group or the like, H may be substituted by another substituent, and X is a halogen ion, and two or more types thereof may be used. In addition, ammonium ions may be partially substituted with other cations, and Pb may be partially substituted with other metal ions), a silicon semiconductor, an inorganic compound semiconductor such as InGaAs, GaAs, chalcopyrite, CdTe, InP, SiGe, or Cu₂O, or a quantum dot-containing or dye-sensitized transparent semiconductor. In either case, the efficiency is high, and the degradation of the output can be further reduced.

A buffer layer may be inserted between the photoelectric conversion layer 503 and the conductive layer 502 to promote or block charge injection.

The counter electrode 504 is typically an opaque metal electrode or carbon electrode, and the transparent electrode according to the embodiment may be used. Another charge buffer layer or charge transport layer may be inserted between the counter electrode 504 and the photoelectric conversion layer 503.

There can be used, as the buffer layer or the charge transport layer for a positive electrode, for example, a layer composed of vanadium oxide, PEDOT/PSS, a p-type polymer, 2,2',7,7'-tetrakis[N,N-di(4-methoxyphenyl)amino]-9,9'-spirobifluorene (hereinafter, referred to as Spiro-OMeTAD), nickel oxide (NiO), tungsten trioxide (WO₃), or molybdenum trioxide (MoOs). The ratio of metal to oxygen in the inorganic oxide is not necessarily a stoichiometric ratio.

Whereas, there can be used, as the buffer layer or the charge transport layer for a transparent electrode serving as a negative electrode, a layer composed of lithium fluoride (LiF), calcium (Ca), 6,6'-phenyl-C₆₁-butyl acid methyl ester (6,6'-phenyl-C₆₁-butyric acid methyl ester, C₆₀-PCBM), 6,6'-phenyl-C71-butyl acid methyl ester (6,6'-phenyl-C71-butyric acid methyl ester, hereinafter referred to as C70-PCBM), indene-C₆₀ bis-adduct (hereinafter referred to as ICBA), cesium carbonate (Cs₂CO₃), titanium dioxide (TiO₂), poly[(9,9-bis(3'-(N,N-dimethylamino)propyl)-2,7-fluorene)-alt-2,7-(9,9-dioctyl-fluorene)] (hereinafter, referred to as PFN), Bathocuproine (hereinafter referred to as BCP), zirconium oxide (ZrO), zinc oxide (ZnO), tin oxide (SnO₂), or polyethyleneimine. The ratio of metal to oxygen in the inorganic oxide is not necessarily a stoichiometric ratio.

A brookite-type titanium oxide layer can be provided between the photoelectric conversion layer and the transparent electrode layer. It is known that titanium oxide has three types of crystal structures of a rutile type, an anatase type, and a brookite type. In the embodiment, of these, it is preferable to use a layer including brookite-type titanium oxide. This brookite-type titanium oxide layer exhibits an effect of suppressing movement of halogen from the photoelectric conversion layer to the conductive layer and movement of metal ions from the conductive layer to the photoelectric conversion layer. Therefore, the life of the electrode and the electronic device can be prolonged. Such a brookite-type titanium oxide layer is preferably composed of nanoparticles of brookite-type titanium oxide, specifically, particles having an average particle size of 5 to 30 nm. Herein, the average particle size has been measured by a particle size distribution measuring apparatus. Such brookite-type nanoparticles are commercially available, for example, from Kojundo Chemical Laboratory Co., Ltd.

An electrode having the same structure as the conductive layer 502 may be used as the counter electrode 504. In addition, the counter electrode 504 may contain unsubstituted planar monolayer graphene. The unsubstituted monolayer graphene can be produced by a CVD method in which a copper foil is used as a base catalyst layer and methane, hydrogen, or argon as a reaction gas. For example, a thermal transfer film and monolayer graphene are pressure-bonded, then copper is dissolved, and the monolayer graphene is transferred onto the thermal transfer film. Repeating the same operation can laminate a plurality of monolayer graphene on the thermal transfer film, and 2 to 4 layers of graphene layers are produced. A metal wiring for current collection is printed on this film by using a silver paste or the like, whereby a counter electrode can be formed. Instead of unsubstituted graphene, graphene in which a part of carbon is substituted with boron may be used. Boron-substituted graphene can be produced in the same manner by using BH₃, methane, hydrogen, or argon as a reaction gas. These graphenes can also be transferred from a thermal transfer film onto a suitable substrate such as PET.

In addition, these monolayer or multilayer graphenes may be doped with a tertiary amine as an electron donor molecule. An electrode composed of such a graphene film also functions as a transparent electrode.

For example, a poly(3,4-ethylenedioxythiophene)-poly(styrenesulfonic acid) composite (PEDOT·PSS) film may be formed as a hole injection layer on the counter electrode. This film can be, for example, 50 nm thick.

The solar battery cell according to the embodiment may have a structure in which both surfaces are sandwiched between transparent electrodes. The solar battery cell having such a structure can efficiently utilize light from both surfaces. The energy conversion efficiency is generally 5% or more, and the solar battery cell is characterized by being stable and flexible for a long period of time.

As the counter electrode 504, an ITO glass transparent electrode can be used instead of the graphene film. In this case, flexibility of the solar battery cell is sacrificed; however, light energy can be used with high efficiency. In addition, there may be used, as a material of such a metal electrode, stainless steel, copper, titanium, nickel, chromium, tungsten, gold, silver, molybdenum, tin, or zinc. In this case, the transparency tends to decrease.

The solar battery cell can further include an ultraviolet cut layer and a gas barrier layer. Specific examples of the ultraviolet absorber include: benzophenone-based compounds such as 2-hydroxy-4-methoxybenzophenone, 2,2-dihydroxy-4-methoxybenzophenone, 2-hydroxy-4-methoxy-2-carboxybenzophenone, and 2-hydroxy-4-n-octoxybenzophenone; benzotriazole-based compounds such as 2-(2-hydroxy-3,5-di-tert-butylphenyl)benzotriazole, 2-(2-hydroxy-5-methylphenyl)benzotriazole, and 2-(2-hydroxy-5-tert-octylphenyl)benzotriazole; and salicylic acid ester-based compounds such as phenyl salicylate and p-octylphenyl salicylate. These desirably cut ultraviolet rays having 400 nm or less.

The gas barrier layer blocking particularly water vapor and oxygen is preferable, and a gas barrier layer that hardly passes water vapor is particularly preferable. For example, a layer composed of an inorganic material of SiN, SiO₂, SiC, SiOₓN_{y}, TiO₂, or Al₂O₃, ultra-thin glass, or the like can be preferably used. The thickness of the gas barrier layer is not particularly limited, and is preferably in the range of 0.01 to 3000 µm, and more preferably in the range of 0.1 to 100 µm. Sufficient gas barrier properties tend not to be obtained at less than 0.01 µm, and whereas, characteristics such as flexibility and softness tend to disappear due to an increase in thickness at more than 3000 µm. The water vapor transmission amount (moisture permeability) of the gas barrier layer is preferably 100 g/m²·d to 10⁻⁶ g/m²·d, more preferably 10 g/m²·d to 10⁻⁵ g/m²·d, and still more preferably 1 g/m²·d to 10⁻⁴ g/m²·d. The moisture permeability can be measured in accordance with JIS Z0208 or the like. A dry method is preferable for forming a gas barrier layer. Examples of a method of forming a gas barrier layer having a gas barrier property by a dry method include: vacuum vapor deposition methods such as a resistance heating vapor deposition, an electron beam vapor deposition, an induction heating vapor deposition, and an assist method using a plasma or an ion beam; sputtering methods such as a reactive sputtering method, an ion beam sputtering method, or an electron cyclotron (ECR) sputtering method; a physical vapor deposition method (PVD method) such as an ion plating method; and a chemical vapor deposition method (CVD method) using heat, light, plasma, or the like. Of these, there is preferable the vacuum vapor deposition method in which a film is formed by a vapor deposition method under vacuum.

When the transparent electrode according to the embodiment includes a substrate, the type of the substrate is selected according to the purpose. Examples of the transparent substrate include an inorganic material such as glass, or an organic material such as PET, PEN, polycarbonate, or PMMA. In particular, use of a flexible organic material is preferable because the transparent electrode according to the embodiment is rich in flexibility.

The solar battery cell of the present embodiment can also be used as a photosensor.

### [Embodiment 3-2]

A configuration of a photoelectric conversion element according to a third another embodiment will be described with reference to FIG. 6. FIG. 6 is a schematic configuration view of the organic EL element 600 (photoelectric conversion element) according to the present embodiment. The organic EL element 600 is an element having a function as a light emitting element that converts electric energy input to this element into light L. The organic EL element 600 includes a photoelectric conversion layer 603 provided on the surface of a conductive layer 602 on a base material 601, and a counter electrode 604 provided on a side surface of the photoelectric conversion layer 603 opposite to the conductive layer 602.

Herein, the conductive layer 602 is similar to that shown in Embodiment 1. The photoelectric conversion layer 603 is an organic thin film layer that recombines the charge injected from the conductive layer 602 and the charge injected from the counter electrode 604 to convert electric energy into light. The photoelectric conversion layer 603 is typically composed of a p-type semiconductor layer and an n-type semiconductor layer. A buffer layer may be provided between the photoelectric conversion layer 603 and the counter electrode 604 to promote or block charge injection, and another buffer layer may also be provided between the photoelectric conversion layer 603 and the conductive layer 602. The counter electrode 604 is typically a metal electrode; however, a transparent electrode may be used.

### (Example 1)

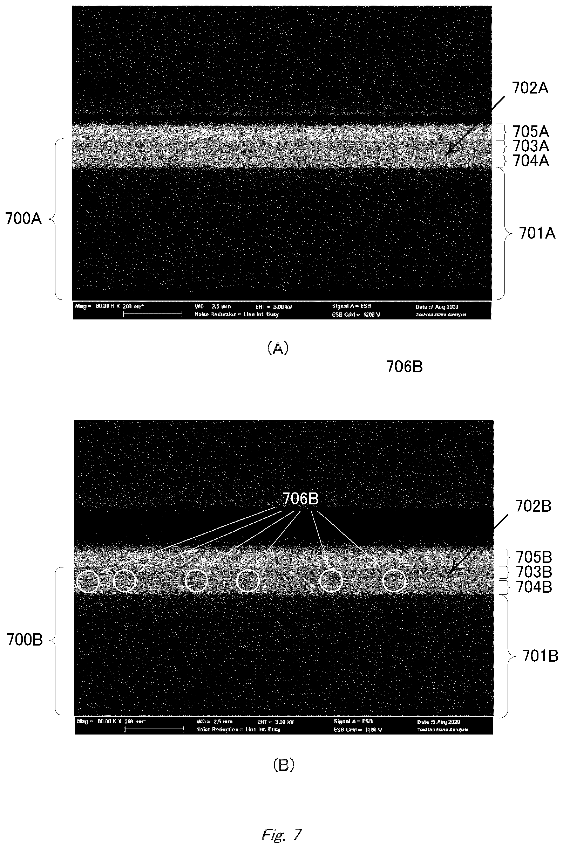

A transparent electrode 700A having a structure corresponding to FIG. 2 is prepared. A transparent electrode 700A having a conductive layer having a laminated structure of an amorphous-containing ITO layer (hereinafter, referred to as an a-ITO layer) 704A (45 to 52 nm)/silver-containing layer 702A (5 to 8 nm)/a-ITO layer 703A (45 to 52 nm) on a PET film 701A having a thickness of 100 µm is prepared by a sputtering method. The surface resistance is 7 to 9 Q/o. This is left in a glass container with sulfur powder in dry air at 80°C for 10 minutes. The surface resistance and the transmission spectrum did not change. A cross-sectional SEM of the obtained transparent electrode is measured. Specifically, FE-SEM (field emission scanning electron microscope, ULTRA55 manufactured by Carl Zeiss Co., Ltd.) is used for the measurement, and observation is able to be performed at an observation voltage of 2.0 kV and a magnification of 80,000 times. The obtained cross-sectional image is shown in FIG. 7(A). In FIG. 7(A), the silver-containing layer 702A is continuous. Reference numeral 705A denotes a metal coating layer for SEM measurement. The ratio Rₜ is 0.92. When the measurement of the response power is performed by cyclic voltammetry at -0.5 to 0.8 V (vs. silver-silver chloride electrode) for 5 min in 0.03 wt% salt water, the increase in surface resistance is 10% or less, showing resistance to ion migration.

### (Comparative Example 1)

A transparent electrode 700B having a conductive layer having a laminated structure of an amorphous ITO layer 704B/a silver-containing layer 702B/an a-ITO layer 703B on a PET film 701B is produced and evaluated in the same manner as in Example 1, except for no treatment with sulfur vapor. The obtained cross-sectional image is shown in FIG. 7(B). In the cross-sectional SEM photograph, a large number of discontinuous regions 706B are observed in the silver-containing layer 702B. In addition, when the measurement of the response power is performed by cyclic voltammetry at -0.5 to 0.8 V (vs. silver-silver chloride electrode) for 5 minutes in 0.03wt% salt water, the surface resistance increased to 300 Ω/□ or more, showing weak resistance to ion migration.

### (Example 2)

A transparent electrode 200 having the structure shown in FIG. 2 is produced. A conductive layer having a laminated structure of a-ITO layer (45 to 52 nm)/silver-containing layer containing silver and a Pd alloy (5 to 8 nm)/a-ITO layer (45 to 52 nm) is prepared on a PET film having a thickness of 100 µm by a sputtering method. The surface resistance is 9 to 10 Ω/□. This is left in a glass container at 30°C for 10 minutes in dry air containing 1% hydrogen sulfide. A cross-sectional SEM of the obtained transparent electrode is measured. The silver-containing layer had no discontinuity and is uniform. The surface resistance and the transmission spectrum are unchanged from those before the sulfur treatment. The ratio Rₜ is 0.85. When the measurement of the response power is performed by cyclic voltammetry at -0.5 to 0.8 V (vs. silver-silver chloride electrode) for 5 min in 0.03 wt% salt water, the increase in surface resistance is 1% or less, showing resistance to ion migration.

### (Comparative Example 2)

The amount of Pd is increased compared with Example 2, and a transparent electrode having a ratio Rₜ of 0.83 is produced. In this case, the light transmittance at 550 nm is 5% lower than that in Example 2, and the light transmittance is insufficient as a transparent electrode for a solar cell.

### (Example 3)

In the same manner as in Example 1, a conductive layer having a laminated structure of a-ITO/silver-containing layer/a-ITO is formed on a PET film having 100 µm by a sputtering method. The surface resistance is 7 to 9 Q/o. This is left in a glass container with sulfur powder in dry air at 80°C for 10 minutes. There is formed thereon a planar shielding layer in which average four layers of N-graphene films with a part of carbon atoms substituted with nitrogen atoms are laminated.

The shielding layer is formed as follows. The surface of the Cu foil is heat-treated by laser irradiation, and the crystal grains are enlarged by annealing. This Cu foil is used as a base catalyst layer, and ammonia, methane, hydrogen, and argon (15 : 60 : 65 : 200 ccm) are used as a mixed reaction gas at 1000°C for 5 minutes to produce a planar monolayer N-graphene film by a CVD method. In this case, a single-layer graphene film is mostly formed, and an N-graphene film having two or more layers is also partially formed depending on the conditions. Furthermore, treatment is performed at 1000°C for 5 minutes under an ammonia/argon mixed gas stream, and then cooling is performed under an argon stream. The monolayer N-graphene film is transferred onto the thermal transfer film by pressure-bonding the thermal transfer film (150 µm thick) and the monolayer N-graphene and then immersing in an ammonia alkaline cupric chloride etchant in order to dissolve Cu. Repeating the same operation laminates four layers of the monolayer graphene films on the thermal transfer film to provide a multilayer N-graphene film.

The thermal transfer film is laminated on the a-ITO layer/silver-containing layer/a-ITO layer/PET film treated with sulfur vapor, and then heated to transfer the N-graphene film onto the a-ITO/silver/a-ITO/PET film to produce a shielding layer.

The nitrogen content measured by XPS is 1 to 2 atom% under this condition. The ratio between carbon atoms and oxygen atoms of the carbon material measured by XPS is 100 to 200.

A cross-sectional SEM of the obtained transparent electrode is measured. The silver-containing layer has no discontinuity and is uniform. The ratio (Rₜ) is 0.93. When the measurement of the response power is performed by cyclic voltammetry at -0.5 to 0.8 V (vs. silver-silver chloride electrode) for 5 min in 0.03 wt% salt water, the increase in surface resistance is 5% or less, showing resistance to ion migration.

### (Example 4)

In the same manner as in Example 1, a conductive layer having a laminated structure of a-ITO layer/silver-containing layer/a-ITO layer is formed on a PET film having 100 µm by a sputtering method. The surface resistance is 7 to 9 Q/o. This is left in a glass container at 30°C for 10 minutes in dry air containing 1% hydrogen sulfide.

An isopropanol solution containing 5wt% of niobium (V) butoxide with respect to titanium (IV) isopropoxide is applied with a bar coater. After drying in nitrogen at room temperature, drying is performed on a hot plate at 130°C in the atmosphere with a humidity of 20% to produce a titanium oxide layer doped with Nb. When the measurement of the response power is performed by cyclic voltammetry at -0.5 to 0.8 V (vs. silver-silver chloride electrode) for 5 min in 0.03 wt% salt water, the increase in surface resistance is 2% or less, showing resistance to ion migration.

### (Example 5)

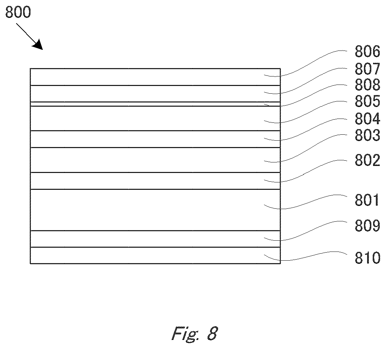

A solar battery cell 800 illustrated in FIG. 8 is produced.

The conductive layer 802 is formed on the base material 801 in the same manner as in Example 1. An aqueous solution of lithium fluoride is applied thereon as the electron injection layer 803, and then a toluene solution of C₆₀-PCBM is applied with a bar coater and dried to form the electron transport layer 804. A chlorobenzene solution including poly(3-hexylthiophene-2,5-diyl) and C₆₀-PCBM is applied with a bar coater and dried at 100°C for 20 minutes to produce a photoelectric conversion layer 805.

The surface of the stainless foil 806 on which the insulating ceramic film is formed on the opposite surface is treated with dilute hydrochloric acid to remove the surface oxide film, and then an aqueous solution of graphene oxide is applied with a bar coater to form a graphene oxide film. Then, the graphene oxide is dried at 90°C for 20 minutes, and then treated with hydrated hydrazine vapor at 110°C for 1 hour to change the graphene oxide to a shielding layer 807 including a two-layer N-graphene film in which a part of carbon atoms of the graphene oxide is substituted with nitrogen atoms.

An aqueous solution of PEDOT/PSS containing sorbitol is applied onto the N-graphene film 806 with a bar coater, and dried at 100°C for 30 minutes to form an adhesive layer 808 (50 nm thick) including PEDOT/PSS.

The surface of the adhesive layer 808 is bonded onto the photoelectric conversion layer 804 at 90°C for contact. The ultraviolet cutting ink containing 2-hydroxy-4-methoxybenzophenone is screen-printed on the PET surface opposite to the conductive layer to produce an ultraviolet cutting layer 809. A silica film is formed on the ultraviolet cutting layer by a vacuum vapor deposition method to produce a gas barrier layer 810, thereby producing a solar battery cell 800.

The obtained solar battery cell exhibits an energy conversion efficiency of 5% or more with respect to 1 SUN of sunlight, and when left outdoors for one month, the efficiency degradation is less than 3%.

### (Example 6)

An organic EL element is prepared. An aqueous solution of lithium fluoride is applied onto the transparent electrode produced in Example 2 as an electron transport layer, and tris(8-hydroxyquinoline)aluminum (Alq₃) (40 nm), which also functions as an n-type semiconductor and is a light emitting layer, is vapor-deposited to produce a photoelectric conversion layer. N,N'-di-1-naphthyl-N,N'-diphenyl-1,1'-biphenyl-4,4'-diamine (hereinafter, referred to as NPD) is vapor-deposited thereon in a thickness of 30 nm to produce a hole transport layer 83. A gold electrode is formed thereon by a sputtering method. Furthermore, the periphery is sealed to produce an organic EL element. The obtained organic EL element has little deterioration in output light, and the reduction in output is 4% or less regardless of continuous operation for 1000 hours.

### (Example 7)

In the same manner as in Example 1, a conductive layer having a laminated structure of a-ITO layer/silver-containing layer/a-ITO layer is formed on a PET film having 100 µm by a sputtering method. The surface resistance is 7 to 9 Q/o. After an ethanol solution of 5 wt% of thioacetamide is applied thereto, heating is performed at 80°C to dry and remove ethanol and surplus thioacetamide. When the measurement of the response power is performed by cyclic voltammetry at -0.5 to 0.8 V (vs. silver-silver chloride electrode) for 5 min in 0.03 wt% salt water, the increase in surface resistance is 8% or less, showing resistance to ion migration.

### (Example 8)

In the same manner as in Example 1, a conductive layer having a laminated structure of a-ITO layer/silver-containing layer/a-ITO layer is formed on a PET film having 100 µm by a sputtering method. The surface resistance is 7 to 9 Q/o. After an ethanol solution of 5 wt% of N-methylthioacetamide is applied thereto, heating is performed at 90°C to dry and remove ethanol and surplus N-methylthioacetamide. When the measurement of the response power is performed by cyclic voltammetry at - 0.5 to 0.8 V (vs. silver-silver chloride electrode) for 5 min in 0.03 wt% salt water, the increase in surface resistance is 10% or less, showing resistance to ion migration.

### (Example 9)

In the same manner as in Example 1, a conductive layer having a laminated structure of a-ITO layer/silver-containing layer/a-ITO layer is formed on a PET film having 100 µm by a sputtering method. The surface resistance is 7 to 9 Q/o. After an ethanol solution of 5 wt% of N-methylthiourea is applied thereto, heating is performed at 100°C to dry and remove ethanol and surplus N-methylthioacetamide. When the measurement of the response power is performed by cyclic voltammetry at - 0.5 to 0.8 V (vs. silver-silver chloride electrode) for 5 min in 0.03 wt% salt water, the increase in surface resistance is 10% or less, showing resistance to ion migration.

### (Example 10)

A transparent electrode 700A having a conductive layer having a laminated structure of a-ITO layer 704A (45 to 52 nm)/silver-containing layer 702A (5 to 8 nm)/a-ITO layer 703A (45 to 52 nm) on a PET film having a thickness of 100 µm, a width of 20 cm, and a length of 40 m is prepared by a roll-to-roll sputtering apparatus. The surface resistance is 7 to 9 Ω/□. This is subjected to sulfur vapor treatment by the apparatus shown in FIG. 4B. When the measurement of the response power is performed by cyclic voltammetry at -0.5 to 0.8 V (vs. silver-silver chloride electrode) for 5 min in 0.03 wt% salt water, the increase in surface resistance is 10% or less, showing resistance to ion migration.

### (Example 11)

In the same manner as in Example 1, a conductive layer having a laminated structure of a-ITO layer/silver-containing layer/a-ITO layer is formed on a PET film having 100 µm by a sputtering method. The surface resistance is 7 to 9 Ω/□.

An isopropanol solution containing 5wt% of niobium (V) butoxide with respect to titanium (IV) isopropoxide is applied with a bar coater. After drying in nitrogen at room temperature, drying is performed on a hot plate at 130°C in the atmosphere with a humidity of 20% to produce a titanium oxide layer doped with Nb. This is left in a glass container with sulfur powder in dry air at 80°C for 10 minutes.

When the measurement of the response power is performed by cyclic voltammetry at -0.5 to 0.8 V (vs. silver-silver chloride electrode) for 5 min in 0.03 wt% salt water, the increase in surface resistance is 2% or less, showing resistance to ion migration.

### (Example 12)

A transparent electrode 700A having a conductive layer having a laminated structure of a-ITO layer 704A (45 to 52 nm)/silver-containing layer 702A (5 to 8 nm)/a-ITO layer 703A (45 to 52 nm) on a PET film having a thickness of 100 µm, a width of 20 cm, and a length of 40 m is prepared by a roll-to-roll sputtering apparatus. The surface resistance is 7 to 9 Ω/□. After an ethanol solution of 5 wt% thioacetamide is applied thereto by a roll-to-roll applicator, the resultant is heated in a roll-to-roll drying furnace to dry and remove ethanol and surplus thioacetamide. Then, a toluene solution of polystyrene is applied by a roll-to-roll applicator, and toluene is evaporated in a roll-to-roll drying furnace. When the measurement of the response power is performed by cyclic voltammetry at -0.5 to 0.8 V (vs. silver-silver chloride electrode) for 5 min in 0.03 wt% salt water, the increase in surface resistance is 1% or less, showing resistance to ion migration.

### REFERENCE SIGNS LIST

100, 200, 300 Transparent electrode
101 Base material
102 Silver-containing layer
103 Oxide layer
104 Second oxide layer
105 Ununiform portion
106 Sulfur-containing silver compound
400 Roll-to-roll sulfur vapor treatment apparatus
401 Laminate film
402 Feed side roll
403 Winding-side roll
404 Heating furnace
405, 406 External air inflow prevention unit
407 Sulfur source
500 Solar battery cell
501 Transparent base material
502 Conductive layer
503 Photoelectric conversion layer
504 Counter electrode
600 Organic EL element
601 Transparent base material
602 Conductive layer
603 Photoelectric conversion layer
604 Counter electrode
700A, 700B Transparent electrode
701A, 701B PET film
702A, 702B Silver-containing layer
703A, 703B Amorphous-containing ITO layer
704A, 704B Amorphous-containing ITO layer
705A, 705B Metal coating layer
706B Discontinuous region
800 Solar battery cell
801 Transparent base material
802 Conductive layer
803 Electron injection layer
804 Electron transport layer
805 Photoelectric conversion layer
806 Stainless foil
807 Shielding layer
808 Adhesive layer
809 Ultraviolet cutting layer
810 Gas barrier layer

## Claims

1. A transparent electrode, comprising a laminated structure in which a conductive silver-containing layer and a first conductive oxide layer are laminated in this order,
wherein a ratio T₈₀₀/T₆₀₀ of a total transmittance of the transparent electrode is 0.85 or more, where T₈₀₀ and T₆₀₀ are transmittances at wavelengths of 800 nm and 600 nm, respectively, and
the silver-containing layer is continuous when a cross section of the transparent electrode is observed with a scanning electron microscope.

2. The transparent electrode according to claim 1, wherein the silver-containing layer includes silver or a silver alloy.

3. *The transparent electrode according to claim 1 or 2, wherein the oxide* is indium-doped tin oxide, fluorine-doped tin oxide, or aluminum-doped zinc oxide.

4. The transparent electrode according to any one of claims 1 to 3, wherein the first conductive oxide layer has an ununiform portion, and the ununiform portion includes a sulfur-containing silver compound layer.

5. The transparent electrode according to any one of claims 1 to 4, wherein an entire surface of the silver-containing layer is covered with the oxide layer or the sulfur-containing silver compound layer.

6. The transparent electrode according to any one of claims 1 to 5, further comprising a graphene layer, a polystyrene layer, or another oxide layer on the first conductive oxide layer.

7. The transparent electrode according to any one of claims 1 to 6, further comprising a transparent base material and comprising a laminated structure in which the silver-containing layer and the first conductive oxide layer are laminated in this order on the transparent base material.

8. The transparent electrode according to claim 7, further comprising a second conductive oxide layer between the transparent base material and the silver-containing layer.

9. A transparent electrode comprising a laminated structure in which a conductive silver-containing layer and a first conductive oxide layer are laminated in this order,
wherein the silver-containing layer is continuous when a cross section of the transparent electrode is observed with a scanning electron microscope, and
the first conductive oxide layer includes a sulfur-containing silver compound.

10. A method for producing a transparent electrode that includes a laminated film in which a conductive silver-containing layer and a first conductive oxide layer are laminated in this order, the method comprising a step (b) of bringing sulfur or a sulfur compound into contact with the laminated film.

11. The method according to claim 10, wherein the step (b) includes:
(b1) bringing the laminated film into contact with a sulfur vapor gas;
(b2) bringing the laminated film into contact with hydrogen sulfide gas;
(b3) bringing the laminated film into contact with an aqueous solution of hydrogen sulfide, sodium sulfide, or ammonium sulfide; or
(b4) contacting the laminated membrane with a solution of thioamide or thiourea.

12. The method according to claim 11, wherein the step (b4) includes applying an alcohol solution of thioamide or thiourea to the laminated film and heating.

13. The method according to any one of claims 10 to 12, wherein in the step (b), a sulfur concentration in the gas, in the aqueous solution, or in the solution is observed, and contact conditions are adjusted based on the observed concentration.

14. The method according to any one of claims 10 to 13, further comprising a step (c) of laminating a graphene layer or a polystyrene layer before or after the step (b).

15. The method according to any one of claims 10 to 14, further comprising a step (d) of laminating a third inorganic oxide layer before or after the step (b).

16. The method according to any one of claims 10 to 15, wherein the laminated film is formed by forming the silver-containing layer on a transparent base material and forming the first conductive oxide layer on the silver-containing layer.

17. The method according to claim 11, wherein the step (b1) or (b2) includes continuously passing the laminated film through an atmosphere of any of the sulfur vapor gas or the hydrogen sulfide gas, and a moisture content or an oxygen content in the atmosphere is controlled not to increase.

18. An electronic device, comprising the transparent electrode according to any one of claims 1 to 9, an active layer, and a counter electrode.

19. An electronic device according to claim 18, wherein the active layer is a photoelectric conversion layer.

20. The electronic device according to claim 18 or 19, wherein the active layer includes a halogen ion.
